# EUROPÄISCHE PATENTSCHRIFT

(11) **EP 3 351 067 B1**
(45) Veröffentlichungstag und Bekanntmachung des Hinweises auf die Patenterteilung: **05.08.2020**
(21) Anmeldenummer: 16756656.1
(22) Anmeldetag: 16.08.2016
(51) Int. Cl.: H05K 7/14, H05K 5/00

(54) **MEDIENDICHTES STEUERGERÄT FÜR EIN KRAFTFAHRZEUG**
MEDIA-TIGHT CONTROL DEVICE FOR A MOTOR VEHICLE
APPAREIL DE COMMANDE ÉTANCHE AUX SUBSTANCES POUR VÉHICULE À MOTEUR

(30) Priorität: 15.09.2015 DE 102015217572
(43) Veröffentlichungstag der Anmeldung: 25.07.2018
(73) Patentinhaber: Conti Temic microelectronic GmbH, 90411 Nürnberg (DE)
(72) Erfinder: WITTMANN, Frieder, 91560 Heilsbronn (DE); BEART, Karin, 91207 Lauf an der Pegnitz (DE); BOCK, Johannes, 91056 Erlangen (DE); SCHMIDT, Thomas, 93133 Burglengenfeld (DE); SCHUCH, Bernhard, 91616 Neusitz (DE)
(74) Vertreter: Bonn, Roman Klemens
(86) Internationale Anmeldenummer: PCT/EP2016/069392
(87) Internationale Veröffentlichungsnummer: WO 2017/045853

(56) Entgegenhaltungen:
- DE-A1-102013 215 230

## Beschreibung

Die Erfindung betrifft ein Steuergerät für ein Kraftfahrzeug nach dem Oberbegriff des Anspruchs 1.

In der Kraftfahrzeugtechnik werden Komponenten wie Getriebe-, Motoren- oder Bremssysteme zunehmend vornehmlich elektronisch gesteuert. Hierbei gibt es eine Entwicklung hin zu integrierten mechatronischen Steuerungen, also zur Integration von Steuerelektronik und den zugehörigen elektronischen Komponenten wie Sensoren oder Ventile in das Getriebe, den Motor oder das Bremssystem. Steuergeräte weisen also im Allgemeinen eine Vielzahl an elektronischen Komponenten auf, welche in Verbindung mit anderen Komponenten außerhalb des Steuergerätes stehen. Bei solchen "Vorort-Elektroniken" sind diese Steuerungen nicht mehr in einem separaten geschützten Elektronikraum untergebracht und müssen daher entsprechenden Umwelteinflüssen und mechanischen, thermischen sowie chemischen Beanspruchungen standhalten.

Sie werden zu diesem Zweck normalerweise in spezielle Gehäuse eingesetzt.

Um eine verlässliche Verbindung zu außerhalb des Gehäuses liegenden Komponenten zu ermöglichen, ist eine elektrische Verbindung von der Gehäuseinnenseite zur Gehäuseaußenseite notwendig.

Die Schaltungsträger für derartige Steuerungen werden in der Regel aufgebaut, in ein Gehäuse eingebracht und anschließend wird dieses Gehäuse verschlossen. Ein Beispiel hierfür wird in der DE 10 2007 038 331 A1 beschrieben. Dieser Gehäuseaufbau garantiert jedoch keine absolute Dichtheit gegen Diffusion bzw. Permeation. Schadgase können im Laufe der Zeit zu dem Schaltungsträger gelangen und zu Metallkorrosion führen.

Bei einem alternativen Konzept wird der komplette Schaltungsaufbau zum Schutz des Schaltungsträgers vollständig mit Moldmasse umgossen. Ein Beispiel hierfür wird in der DE 10 2011 082 537 Al beschrieben. Die Prozessführung des Moldprozesses muss dabei genau eingehalten werden. Ansonsten kann es bei der Verwendung von ungehäusten elektronischen Bauteilen, sogenannten Bare Dies, die mittels Gold-Draht-Verbindungen mit dem Schaltungsträger elektrisch verbunden sind, zu sogenannten Bonddrahtverwehungen kommen. Ferner muss der thermische Ausdehnungskoeffizient des Moldmaterials genau an den des Gesamtaufbaus, bestehend aus Trägersubstrat, Bauteile usw. angepasst sein. Ansonsten kann es bei Temperaturbelastungen zu Spaltbildung zwischen Moldmasse und Aufbau kommen.

Eine weitere Möglichkeit des Abdichtens des Schaltungsraumes ist das Verschweißen des Gehäuses mit einem Edelstahldeckel. Dieses Verfahren ist vergleichsweise kostenintensiv und die elektrischen Anschlüsse müssen insbesondere über Glasdurchführungen vom Schaltungsträger durch das Edelstahlgehäuse nach außen geführt werden. Hier kann es leicht zu Fehlern im Prozess kommen. Des Weiteren können Gase, die durch den Schweißprozess im Gehäuseinneren entstehen, nur schwer wieder abgeführt werden.

Die DE 10 2013 215 230 A1 offenbart ein mediendichtes Umspritzen des Randbereiches zwischen einem Gehäusedeckel und einer Verbindungsvorrichtung mit einem Polymer.

Der Erfindung liegt die Aufgabe zu Grunde, ein Steuergerät für ein Kraftfahrzeug zu schaffen, das einen vollständigen Schutz von Schaltung und Schaltungsträger gegen Schadgase und gegen aggressive Medien wie Getriebeöl bietet und gleichzeitig im Vergleich zu bisher bekannten Steuergeräten zu einer Reduzierung der Herstellungskosten führt.

Erfindungsgemäß wird ein Steuergerät beschrieben, das einen Gehäusedeckel mit einem umlaufenden, insbesondere planen Randbereich und eine flächige, elektrische Verbindungsvorrichtung mit integrierten Leiterbahnen umfasst, wobei der Gehäusedeckel im Randbereich mit der Verbindungsvorrichtung unter Bildung einer Verbindungsnaht zumindest abschnittsweise stoffschlüssig verbunden ist und mit der Verbindungsvorrichtung einen Hohlraum einschließt. Die stoffschlüssige Verbindung zwischen dem Gehäusedeckel und der Verbindungsvorrichtung ist insbesondere mittels Kleben, Laminieren oder Löten hergestellt.

Auf der Verbindungsvorrichtung ist mindestens ein elektronisches Bauteil innerhalb des Hohlraums angeordnet und die Verbindungsvorrichtung verbindet dieses elektronische Bauteil mit elektronischen Bauteilen außerhalb des Hohlraums elektrisch. Der umlaufende Randbereich des Gehäusedeckels ist dabei mindestens im Bereich der Verbindungsnaht zwischen dem Gehäusedeckel und der Verbindungsvorrichtung mit einem Polymer mediendicht umspritzt, wobei der Gehäusedeckel bevorzugt aus Kunststoff oder aus Metall ist und das Polymer vorwiegend als Moldmaterial, als Kleber oder als Harz ausgeführt ist.

Die elektronischen Bauteile umfassen beispielsweise Kondensatoren, Spulen oder einen Mikroprozessor. In der Regel sind die elektronischen Bauteile über Leiterbahnen der Verbindungsvorrichtung und/oder mittels gebondeter Golddrähte miteinander elektrisch verbunden.

Der Gehäusedeckel schützt die elektronischen Bauteile im Inneren des Steuergerätgehäuses vor Ölen, insbesondere aggressiven Ölen, sowie schädlichen Gasen und Chemikalien. Weiterhin sind die elektronischen Bauteile vor Salzen oder Verarbeitungsrückständen geschützt. Die Öle, Gase, Salze und/oder Rückstände liegen beispielsweise in einem Getriebe vor, an welchem oder innerhalb welchem das Steuergerät angeordnet ist. Auch die entsprechenden Leiterbahnen werden von dem Gehäusedeckel geschützt. Hierzu ist der Deckel, wie bereits erwähnt, im Randbereich stoffschlüssig mit der Verbindungsvorrichtung so verbunden, dass mit der Verbindungsvorrichtung ein abgeschlossener Hohlraum um die elektronischen Bauteile gebildet wird. Zusätzlich ist der umlaufende Randbereich des Gehäusedeckels mindestens im Bereich der Verbindungsnaht zwischen dem Gehäusedeckel und der Verbindungsvorrichtung mit einem Polymer umspritzt, und somit ist der Steuergerätaufbau gegen die Umgebung hermetisch abgedichtet.

Im Gegensatz zu formschlüssig verbundenen Deckeln können keine Fluide und/oder Gase in den Hohlraum eintreten. Somit sind die elektronischen Komponenten versiegelt und gegen die Umwelt abgedichtet. Zusätzlich kann auf gummiartige Dichtungen verzichtet werden, welche insbesondere bei formschlüssig angebundenen Deckeln verwendet werden. Diese Dichtungen würden keine vollständige Gasdichtigkeit garantieren, da die Gase im Laufe der Zeit durch derartige Dichtungen in erheblichem Maße diffundieren können.

Insbesondere umfassen die Chemikalien beziehungsweise Gase Schwefelverbindungen, wodurch Sulfide entstehen können. Sulfide sind zumindest teilweise stromleitend und würden sich an ungeschützten elektronischen Komponenten, den Leiterbahnen der Verbindungsvorrichtung und/oder den Golddrähten ablagern. Dabei kann es zu chemischen Reaktionen mit den Sulfiden kommen. Beispielsweise oxidieren die Leiterbahnen der Verbindungsvorrichtung, insbesondere Silberleiterbahnen, mit den Schwefelverbindungen. Dabei können sich Leitungswiderstände und/oder Funktionen der elektronischen Komponenten verändern und beispielsweise das Schaltverhalten eines Getriebes negativ beeinflussen. Weiterhin können derartige Gase Signalveränderungen bewirken, sodass es beispielsweise zu fehlerhaften Auswertungen durch die Steuergerätevorrichtung kommt.

Insgesamt wird somit mittels des beschriebenen Aufbaus die Lebensdauer und die Genauigkeit des Steuergeräts verbessert. Weiter ist das beschriebene Steuergerät als vorgefertigtes Modul für eine Anwendung vorort wie beispielsweise im Getriebe oder als Anbausteuergerät realisierbar.

Gemäß einer weiteren Ausgestaltung ist die Verbindungsvorrichtung als Leiterplatte mit mindestens einer Lage ausgeführt. Die Leiterplatte ist beispielsweise eine faserverstärkte Kunststoff- oder eine Keramikleiterplatte. Es könnte aber auch eine sogenannte HDI-Leiterplatte (High-Density-Interconnect) verwendet werden, welche sehr kompakt ausgestaltet ist. Die durchgehende Leiterplatte ragt hier über den gesamten umlaufenden Randbereich des Gehäusedeckels hinaus und bildet gleichzeitig den Boden des Gehäuses. Dadurch wird insbesondere ein flacher Aufbau des Steuergerätes erreicht.

Um eine zusätzliche Versteifung dieses Aufbaus zu erreichen bzw. eine unter Umständen auftretende Verwölbung des Aufbaus im Bereich der Leiterplatte auszugleichen, kann der auf der dem Gehäusedeckel abgewandten Seite der Leiterplatte in dem der Verbindungsnaht entsprechenden Bereich zusätzlich Polymer aufgespritzt sein.

Um den Niveauunterschied zwischen dem Randbereich des Deckels und der Leiterplatte im Bereich der Umspritzung zu vermindern bzw. zu egalisieren, verläuft der umlaufende Randbereich des Gehäusedeckels vorteilhafter Weise in einer entsprechenden umlaufenden Nut in der Leiterplatte. Dadurch wird das Risiko einer Spaltbildung in der Umspritzung im Bereich der Verbindungsstelle reduziert.

Gemäß einer weiteren Ausgestaltung ist die Verbindungsvorrichtung zum Teil als separater Schaltungsträger im Inneren des Hohlraums angeordnet, wobei auf dem separaten Schaltungsträger das mindestens eine elektronische Bauteil wie Kondensator, Spule oder Mikroprozessor angeordnet ist. Die elektronischen Bauteile sind insbesondere über Leiterbahnen des Schaltungsträgers und/oder mittels gebondeter Golddrähte miteinander elektrisch verbunden. Der separate Schaltungsträger ist beispielsweise eine faserverstärkte Kunststoff- oder eine Keramikleiterplatte mit je einer oder mehreren Lagen. Alternativ könnte aber auch eine sogenannte HDI-Leiterplatte (High-Density-Interconnect) verwendet werden, welche konstruktionsbedingt sehr kompakt ausgestaltet ist.

Das mindestens eine elektronische Bauteil auf dem separaten Schaltungsträger ist bevorzugt mittels einer separaten Leiterplatte mit elektronischen Bauteilen außerhalb des Hohlraums elektrisch verbunden. Als separate Leiterplatte wird insbesondere eine flexible Leiterplatte, die ganzflächig, mit einer Aussparung zur Aufnahme des separaten Schaltungsträgers, oder streifenförmig ausgeführt ist, verwendet. Bei diesem Ausführungsbeispiel sind der separate Schaltungsträger und die separate Leiterplatte auf einer gemeinsamen, über den gesamten umlaufenden Randbereich des Gehäusedeckels hinausragenden Trägerplatte angeordnet. Hier wird der Hohlraum im Steuergerät im Wesentlichen durch den Gehäusedeckel und die Trägerplatte umschlossen. In der Regel ist die Trägerplatte wegen ihrer Anforderungen in Bezug auf Steifigkeit und Wärmeableitvermögen aus Metall, insbesondere aus Aluminium gefertigt. Wird als separate Leiterplatte eine Flexfolie verwendet, so ist diese bevorzugt auf die Trägerplatte auflamimniert. Wenn die flexible Leiterplatte vollflächig mit einer Aussparung zur Aufnahme des Schaltungsträgers ausgeführt ist, wird diese im Wesentlichen vom Randbereich des Gehäusedeckels vollständig umlaufend überdeckt. Wenn die flexible Leiterplatte streifenförmig ausgeführt ist, wird diese vom umlaufenden Randbereich des Gehäusedeckels naturgemäß nur abschnittsweise, in der Regel quer zu den Leiterbahnen überdeckt.

In einer weiteren Ausgestaltung verläuft der umlaufende Randbereich des Gehäusedeckels vorteilhafter Weise in einer entsprechenden umlaufenden Nut in der Trägerplatte. Dadurch wird der Niveauunterschied zwischen dem Randbereich des Deckels und Trägerplatte im Bereich der Umspritzung verkleinert oder gar egalisiert und somit das Risiko einer Spaltbildung im Polymer im Bereich der Verbindungsnaht reduziert.

Weitere Merkmale, Vorteile und Einzelheiten sind der nachfolgenden Beschreibung entnehmbar, in der bevorzugte Ausführungsbeispiele näher erläutert werden. Es zeigen:
- Fig. 1: einen Schnitt durch ein Steuergerät mit einer durchgehenden Leiterplatte als Verbindungsvorrichtung,
- Fig. 2: ein Steuergerät wie in der Figur 1, mit beidseitig aufgebrachtem Polymer,
- Fig. 3: einen Schnitt durch ein Steuergerät mit einem separaten Schaltungsträger und einer separaten Leiterplatte,
- Fig. 4: eine Draufsicht auf ein Steuergerät, und
- Fig. 5: ein Steuergerät wie in der Figur 3, jedoch mit einer Nut in der Trägerplatte.

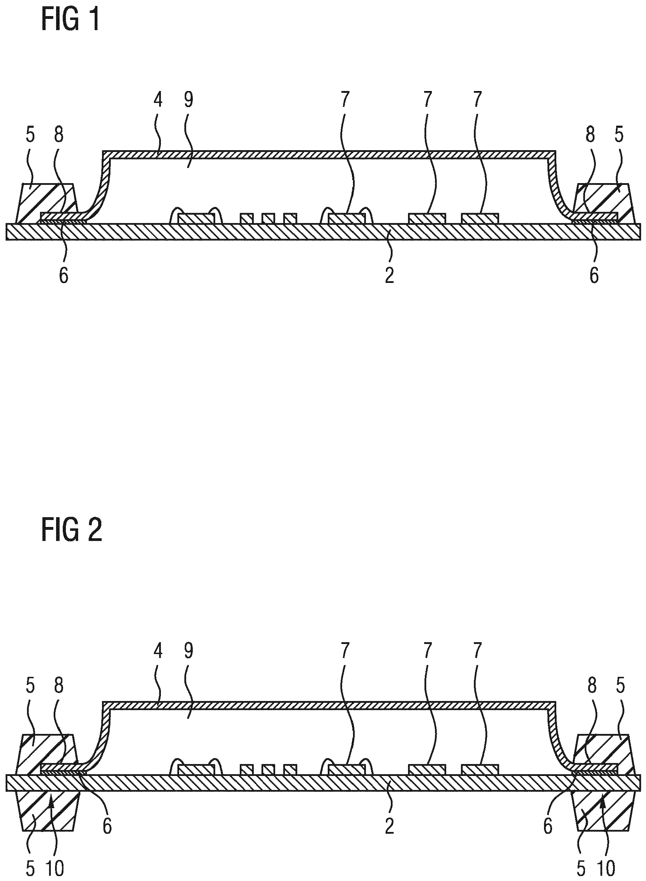

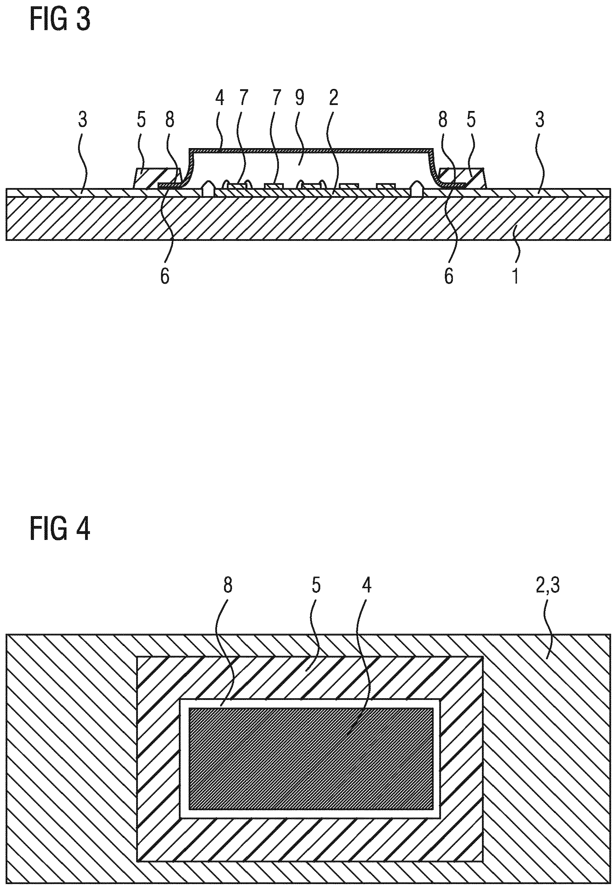

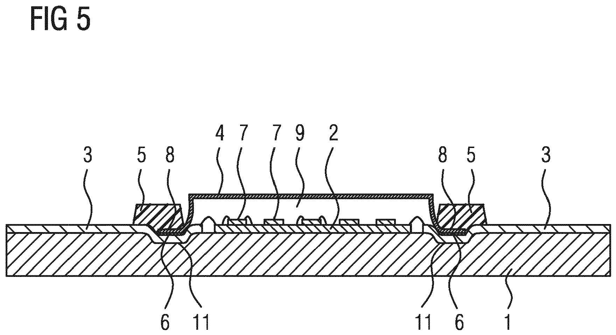

Figuren 1 und 2, bzw. 3 und 5 zeigen schematische Schnittansichten eines Steuergerätes gemäß zweier unterschiedlicher Ausführungsprinzipien, wobei Fig. 1 und Fig. 2 das erste und Fig. 3 und 5 das zweite Ausführungsprinzip wiedergeben. Zunächst werden Gemeinsamkeiten der zwei Ausführungsprinzipien beschrieben, ehe auf die Unterschiede eingegangen wird.

Bei den Ausführungsbeispielen handelt es sich um ein Steuergerät eines Automatikgetriebes eines Kraftfahrzeuges. Das Steuergerät vermag beispielsweise Messwerte von Sensoren wie Hall-Sensoren auszuwerten und eine Schaltung des Automatikgetriebes in Abhängigkeit der Messwerte zu steuern. Alternativ kann das Steuergerät auch für andere Einsatzzwecke wie zum Beispiel in einem Motor eines Kraftfahrzeuges vorgesehen sein.

Jedes Steuergerät weist eine Verbindungsvorrichtung 2, 3 auf. Auf der Verbindungsvorrichtung 2, 3 ist eine Mehrzahl von elektronischen Bauteilen 7 angeordnet. Diese umfassen beispielsweise Kondensatoren, Spulen, wenigstens einen Mikroprozessor und/oder andere Komponenten. Die elektronischen Bauteile 7 sind miteinander elektrisch verbunden, insbesondere über gebondete Golddrähte und/oder Leiterbahnen der Verbindungsvorrichtung 2, 3.

Zum Schutz der elektronischen Bauteile 7 und der entsprechenden Leiterbahnen ist ein gasundurchlässiger Gehäusedeckel 4 in seinem Randbereich 8 mit der Verbindungsvorrichtung 2, 3 unter Ausbildung einer umlaufenden Verbindungsnaht 6 stoffschlüssig verbunden. Die stoffschlüssige Verbindung zwischen dem Gehäusedeckel 4 und der Verbindungsvorrichtung 2, 3 ist mittels Kleben hergestellt. Diese Verbindung kann aber auch zum Beispiel durch Laminieren oder Löten realisiert sein. Der Gehäusedeckel 4 ist wahlweise aus Metall oder Kunststoff gefertigt.

Der Gehäusedeckel 4 umschließt mit der Verbindungsvorrichtung 2, 3 einen abgeschlossenen Hohlraum 9. Somit ist die stoffschlüssige Verbindungsnaht 6 zusammenhängend zwischen dem Gehäusedeckel 4 und der Verbindungsvorrichtung 2, 3 um die elektronischen Bauteile 7 ausgebildet.

Die Verbindungsvorrichtung 2, 3 verbindet die elektronischen Bauteile 7 im Inneren des Steuergeräts mit hier nicht gezeigten elektronischen Bauteilen außerhalb des Hohlraums 9 bzw. Steuergeräts elektrisch. Der umlaufende Randbereich 8 des Gehäusedeckels 4 ist dabei mindestens im Bereich der Verbindungsnaht 6 zwischen dem Gehäusedeckel 4 und der Verbindungsvorrichtung 2, 3 mit einem Polymer 5 insbesondere derart umspritzt, dass der Randbereich 8 in Richtung Deckel 4 der Breite des Randbereichs 8 nach im Wesentlichen vollständig mit Polymer 5 bedeckt ist und sich das Polymer 5 in der entgegengesetzten Richtung, vom Gehäusedeckel 4 abgewandt, über den Randbereich 8 hinaus über die Verbindungsvorrichtung 2,3 beispielsweise zumindest der selben Breite nach erstreckt. Die Breite der Umspritzung hängt unter anderem von der Art des verwendeten Polymers und von der Oberflächenbeschaffenheit der umspritzten Flächen ab. Zum Beispiel können der Randbereich 8 und die Verbindungsvorrichtung 2,3 jeweils plan ausgeführt sein, oder eine entsprechende Struktur aufweisen, die im zusammengefügten Zustand zu einer verbesserten Festigkeit und Dichtheit der Verbindung, vor allem über die Lebensdauer, erzeugen. Dadurch ist sichergestellt, dass der Bereich der Verbindungsnaht 6 zwischen dem Gehäusedeckel 4 und der Verbindungsvorrichtung 2, 3 ausreichend mit Polymermaterial 5 bedeckt ist, und somit der Steuergerätaufbau gegen die Umgebung, beispielweise Öle, insbesondere aggressive Öle, sowie schädliche Gase und Chemikalien hermetisch abgedichtet ist. Das Polymer 5 ist als Moldmaterial, alternativ dazu als Kleber oder als Harz ausgeführt.

Im Folgenden werden die Unterschiede der zwei Ausführungsprinzipien gemäß den Figuren 1 bis 5 erläutert.

Im Ausführungsbeispiel gemäß Figur 1 ist die Verbindungsvorrichtung als Leiterplatte 2 mit mindestens einer Lage ausgeführt. Die Leiterplatte 2 ist beispielsweise eine faserverstärkte Kunststoff-, eine Keramikleiterplatte oder eine HDI-Leiterplatte. Die durchgehende Leiterplatte 2 ragt hier über den gesamten umlaufenden Randbereich 8 des Gehäusedeckels 4 hinaus und bildet gleichzeitig den Boden des Steuergerätgehäuses. Dadurch wird insbesondere ein flacher Aufbau des Steuergerätes erreicht.

Um eine zusätzliche Versteifung des Steuergeräteaufbaus zu erreichen bzw. um eine unter Umständen auftretende Verwölbung des Aufbaus im Bereich der Leiterplatte 2 auszugleichen, kann, wie in Fig. 2 gezeigt, auf der dem Gehäusedeckel 4 abgewandten Seite der Leiterplatte 2 in dem der Verbindungsnaht 6 entsprechenden Bereich 10 zusätzlich Polymer 5 aufgespritzt sein.

Im Ausführungsbeispiel gemäß Figur 3 umfasst die Verbindungsvorrichtung 2, 3 einen separaten Schaltungsträger 2, auf dem alle elektronischen Bauteile 7 angeordnet sind, und eine separate Leiterplatte 3 mittels der die elektronischen Bauteile 7 im Inneren des Steuergerätes mit nicht gezeigten elektronischen Bauteilen außerhalb des Steuergerätes elektrisch verbunden sind. Der separate Schaltungsträger 2 und die separate Leiterplatte 3 sind hier mittels Bonddrähten verbunden. Der separate Schaltungsträger 2 und die separate Leiterplatte 3 sind auf einer gemeinsamen, über den gesamten umlaufenden Randbereich 8 des Gehäusedeckels 4 hinaus ragenden Trägerplatte 1 angeordnet. Hier wird der Hohlraum 9 im Wesentlichen durch den Gehäusedeckel 4 und die Trägerplatte 1 umschlossen.

Der separate Schaltungsträger 2 ist als eine faserverstärkte Kunststoffleiterplatte oder alternativ als eine Keramikleiterplatte oder HDI-Leiterplatte mit jeweils einer oder mehreren Lagen ausgeführt. Es können jedoch auch andere Ausgestaltungsformen eines Schaltungsträgers Verwendung finden. Die elektronischen Bauteile 7 sind miteinander elektrisch verbunden, insbesondere über gebondete Golddrähte und/oder Leiterbahnen des separaten Schaltungsträgers 2.

Als separate Leiterplatte 3 wird bevorzugt eine flexible Leiterplatte aus Polyimid verwendet. Diese flexible Leiterplatte 3 ist entweder als geschlossenen Fläche, mit einer Aussparung zur Aufnahme des Schaltungsträgers 2, oder streifenförmig ausgeführt.

Üblicherweise ist die Trägerplatte wegen ihrer Anforderungen in Bezug auf Steifigkeit und Wärmeableitvermögen aus Metall, insbesondere aus Aluminium gefertigt. Der separate Schaltungsträger 2 und die separate Leiterplatte 3 sind auf die Trägerplatte 1 üblicherweise geklebt oder laminiert. Wenn die flexible Leiterplatte 3 ganzflächig ausgeführt ist, wird diese im Wesentlichen vom Randbereich 8 des Gehäusedeckels 4 vollständig umlaufend überdeckt.

Falls die flexible Leiterplatte 3 streifenförmig ausgeführt ist, wird diese vom umlaufenden Randbereich 8 des Gehäusedeckels 4 konstruktionsbedingt nur abschnittsweise, in der Regel quer zu den Leiterbahnen der Leiterplatte 3 überdeckt. Die Verbindungsnaht 6 erstreckt sich somit auf der einen Seite über den umlaufenden Randbereich 8 und auf der anderen Seite über die Streifen der Leiterplatte 3 bzw. die Trägerplatte 1.

Fig. 5 zeigt ein Steuergerät wie in Fig. 3, jedoch verläuft der umlaufende Randbereich 8 des Gehäusedeckels 4 in einer entsprechenden umlaufenden Nut 11 in der Trägerplatte 1. Dadurch wird der Niveauunterschied zwischen dem Randbereich 8 und der Trägerplatte 1 im Bereich der Umspritzung 5 verkleinert bzw. egalisiert und somit das Risiko einer Spaltbildung im Polymer 5 im Bereich der Verbindungsnaht 6 reduziert.

Eine derartige Nut wäre auch im ersten Ausführungsprinzip gemäß den Figuren 1 und 2 entsprechend in der Leiterplatte 2 denkbar.

Fig. 4 zeigt eine Draufsicht auf ein Steuergerät gemäß den beiden Ausführungsprinzipien. Der Gehäusedeckel 4 ist auf der Verbindungsvorrichtung 2, 3 angeordnet. Der umlaufende Randbereich 8 des Gehäusedeckels ist mit einem Polymer 5 mediendicht umspritzt.

### Bezugszeichenliste

- 1: Trägerplatte
- 2: Verbindungsvorrichtung, separater Schaltungsträger
- 3: Verbindungsvorrichtung, separate Leiterplatte
- 4: Gehäusedeckel
- 5: Polymer
- 6: Verbindungsnaht
- 7: Bauteil
- 8: umlaufenden Randbereich des Gehäusedeckels 4
- 9: Hohlraum
- 10: Bereich
- 11: Nut

## Patentansprüche

1. Steuergerät für ein Kraftfahrzeug, umfassend
a) einen Gehäusedeckel (4) mit einem umlaufenden Randbereich (8),
b) eine flächige, elektrische Verbindungsvorrichtung (2, 3) mit integrierten Leiterbahnen, wobei der Gehäusedeckel (4) im Randbereich (8) zumindest mit der Verbindungsvorrichtung (2, 3) unter Ausbildung einer Verbindungsnaht (6) stoffschlüssig verbunden ist und mit der Verbindungsvorrichtung (2, 3) einen Hohlraum (9) bildet,
c) mindestens ein elektronisches Bauteil (7) innerhalb des Hohlraums (9), wobei die Verbindungsvorrichtung (2, 3) das mindestens eine elektronische Bauteil (7) mit elektronischen Bauteilen außerhalb des Hohlraums (9) elektrisch verbindet, wobei der umlaufende Randbereich (8) mindestens im Bereich der Verbindungsnaht (6) zwischen dem Gehäusedeckel (4) und der Verbindungsvorrichtung (2, 3) mit einem Polymer (5) mediendicht umspritzt ist.

2. Steuergerät nach Anspruch 1, **dadurch gekennzeichnet, dass** die Verbindungsvorrichtung (2) als Leiterplatte mit mindestens einer Lage ausgeführt ist, wobei die Leiterplatte (2) über den gesamten umlaufenden Randbereich (8) des Gehäusedeckels (4) hinausragt.

3. Steuergerät nach Anspruch 2, **dadurch gekennzeichnet, dass** auf der dem Gehäusedeckel (4) abgewandten Seite der Leiterplatte (2) in dem der Verbindungsnaht (6) entsprechenden Bereich (10) zusätzlich Polymer (5) aufgespritzt ist.

4. Steuergerät nach Anspruch 2 oder 3, **dadurch gekennzeichnet, dass** der umlaufende Randbereich (8) des Gehäusedeckels (4) in einer umlaufenden Nut (11) in der Leiterplatte (2) verläuft .

5. Steuergerät nach Anspruch 1, **dadurch gekennzeichnet, dass** die Verbindungsvorrichtung einen separaten Schaltungsträger (2), eine separate Leiterplatte (3) und eine Trägerplatte (1) aufweist, wobei der separate Schaltungsträger (2) im Inneren des Hohlraums (9) angeordnet ist, wobei auf dem Schaltungsträger (2) das mindestens eine elektronische Bauteil (7) angeordnet ist, welches mittels der separaten Leiterplatte (3) mit elektronischen Bauteilen außerhalb des Hohlraums (9) elektrisch verbunden ist, und wobei der separate Schaltungsträger (2) und die separate Leiterplatte (3) auf der gemeinsamen Trägerplatte (1) angeordnet sind, wobei die Trägerplatte (1) über den gesamten umlaufenden Bereich (8) des Gehäusedeckels (4) hinausragt.

6. Steuergerät nach Anspruch 5, **dadurch gekennzeichnet, dass** die separate Leiterplatte (3) als flexible Leiterplatte ausgeführt ist.

7. Steuergerät nach Anspruch 5 oder 6, **dadurch gekennzeichnet, dass** die separate Leiterplatte (3) zumindest abschnittsweise von dem umlaufenden Randbereich (8) überdeckt ist.

8. Steuergerät nach einem der Ansprüche 5 bis 7, **dadurch gekennzeichnet, dass** die Trägerplatte (1) aus Metall, zum Beispiel Aluminium ist.

9. Steuergerät nach einem der Ansprüche 5 bis 8, **dadurch gekennzeichnet, dass** der umlaufende Randbereich (8) des Gehäusedeckels (4) in einer umlaufenden Nut (11) in der Trägerplatte (1) verläuft.

10. Steuergerät nach einem der vorhergehenden Ansprüche, **dadurch gekennzeichnet, dass** das Polymer als Moldmaterial, als Kleber oder als Harz ausgeführt ist.

11. Steuergerät nach einem der vorhergehenden Ansprüche, **dadurch gekennzeichnet, dass** der Gehäusedeckel (4) aus Kunststoff oder aus Metall ist.

12. Steuergerät nach einem der vorhergehenden Ansprüche, **dadurch gekennzeichnet, dass** die stoffschlüssige Verbindung zwischen Gehäusedeckel (4) und der Verbindungsvorrichtung (2, 3) mittels Kleben, Laminieren oder Löten hergestellt ist.

## Claims

1. Control device for a motor vehicle, comprising
a) a housing cover (4) with a peripheral edge region (8),
b) a flat, electrical connecting apparatus (2, 3) with integrated conductor tracks, wherein the housing cover (4), in the edge region (8), is cohesively connected at least to the connecting apparatus (2, 3) so as to form a connecting seam (6) and forms a cavity (9) with the connecting apparatus (2, 3),
c) at least one electronic component (7) within the cavity (9), wherein the connecting apparatus (2, 3) electrically connects the at least one electronic component (7) to electronic components outside the cavity (9), wherein the peripheral edge region (8) is encapsulated by injection-moulding in a media-tight manner by a polymer (5) at least in the region of the connecting seam (6) between the housing cover (4) and the connecting apparatus (2, 3).

2. Control device according to Claim 1, **characterized in that** the connecting apparatus (2) is designed as a printed circuit board with at least one layer, wherein the printed circuit board (2) projects beyond the entire peripheral edge region (8) of the housing cover (4).

3. Control device according to Claim 2, **characterized in that** polymer (5) is additionally sprayed onto that side of the printed circuit board (2) which is averted from the housing cover (4) in the region (10) which corresponds to the connecting seam (6).

4. Control device according to Claim 2 or 3, **characterized in that** the peripheral edge region (8) of the housing cover (4) runs in a peripheral groove (11) in the printed circuit board (2) .

5. Control device according to Claim 1, **characterized in that** the connecting apparatus has a separate circuit carrier (2), a separate printed circuit board (3) and a carrier plate (1), wherein the separate circuit carrier (2) is arranged in the interior of the cavity (9), wherein the at least one electronic component (7) which is electrically connected to electronic components outside the cavity (9) by means of the separate printed circuit board (3) is arranged on the circuit carrier (2), and wherein the separate circuit carrier (2) and the separate printed circuit board (3) are arranged on the common carrier plate (1), wherein the carrier plate (1) projects beyond the entire peripheral region (8) of the housing cover (4) .

6. Control device according to Claim 5, **characterized in that** the separate printed circuit board (3) is designed as a flexible printed circuit board.

7. Control device according to Claim 5 or 6, **characterized in that** the separate printed circuit board (3) is overlapped at least in sections by the peripheral edge region (8).

8. Control device according to one of Claims 5 to 7, **characterized in that** the carrier plate (1) is composed of metal, for example aluminium.

9. Control device according to one of Claims 5 to 8, **characterized in that** the peripheral edge region (8) of the housing cover (4) runs in a peripheral groove (11) in the carrier plate (1).

10. Control device according to one of the preceding claims, **characterized in that** the polymer is designed as moulding material, as adhesive or as resin.

11. Control device according to one of the preceding claims, **characterized in that** the housing cover (4) is composed of plastic or of metal.

12. Control device according to one of the preceding claims, **characterized in that** the cohesive connection between the housing cover (4) and the connecting apparatus (2, 3) is established by means of adhesive bonding, lamination or soldering.

## Revendications

1. Contrôleur pour un véhicule automobile, comprenant
a) un couvercle de boîtier (4) doté d'une zone de bordure (8) périphérique,
b) un dispositif de liaison (2, 3) électrique plat avec des pistes conductrices intégrées, le couvercle de boîtier (4) étant relié par fusion de matières dans la zone de bordure (8) au moins avec le dispositif de liaison (2, 3) en formant un cordon de liaison (6) et formant un espace creux (9) avec le dispositif de liaison (2, 3),
c) au moins un composant électronique (7) à l'intérieur de l'espace creux (9), le dispositif de liaison (2, 3) reliant électriquement l'au moins un composant électronique (7) à des composants électroniques à l'extérieur de l'espace creux (9), la zone de bordure (8) périphérique étant enrobée de polymère (5) de manière étanche aux fluides au moins dans la zone du cordon de liaison (6) entre le couvercle de boîtier (4) et le dispositif de liaison (2, 3).

2. Contrôleur selon la revendication 1, **caractérisé en ce que** le dispositif de liaison (2) est réalisé sous la forme d'un circuit imprimé ayant au moins une couche, le circuit imprimé (2) faisant saillie hors de la totalité de la zone de bordure (8) périphérique du couvercle de boîtier (4).

3. Contrôleur selon la revendication 2, **caractérisé en ce que** du polymère (5) supplémentaire est appliqué par pulvérisation sur le côté du circuit imprimé (2) à l'opposé du couvercle de boîtier (4), dans la zone (10) correspondant au cordon de liaison (6) .

4. Contrôleur selon la revendication 2 ou 3, **caractérisé en ce que** la zone de bordure (8) périphérique du couvercle de boîtier (4) s'étend dans une rainure périphérique (11) dans le circuit imprimé (2).

5. Contrôleur selon la revendication 1, **caractérisé en ce que** le dispositif de liaison possède un porte-circuit séparé (2), un circuit imprimé séparé (3) et une plaque porteuse (1), le porte-circuit séparé (2) étant disposé à l'intérieur de l'espace creux (9), l'au moins un composant électronique (7) étant disposé sur le porte-circuit (2) et étant relié à des composants électroniques à l'extérieur de l'espace creux (9) au moyen du circuit imprimé séparé (3), et le porte-circuit séparé (2) et le circuit imprimé séparé (3) étant disposés sur la plaque porteuse (1) commune, la plaque porteuse (1) faisant saillie hors de la totalité de la zone de bordure (8) périphérique du couvercle de boîtier (4).

6. Contrôleur selon la revendication 5, **caractérisé en ce que** le circuit imprimé séparé (3) est réalisé sous la forme d'un circuit imprimé souple.

7. Contrôleur selon la revendication 5 ou 6, **caractérisé en ce que** le circuit imprimé séparé (3) est recouvert par la zone de bordure (8) périphérique au moins dans certaines portions.

8. Contrôleur selon l'une des revendications 5 à 7, **caractérisé en ce que** la plaque porteuse (1) est en métal, par exemple en aluminium.

9. Contrôleur selon l'une des revendications 5 à 8, **caractérisé en ce que** la zone de bordure (8) périphérique du couvercle de boîtier (4) s'étend dans une rainure périphérique (11) dans la plaque porteuse (1).

10. Contrôleur selon l'une des revendications précédentes, **caractérisé en ce que** le polymère est réalisé sous la forme d'un matériau de moulage, sous la forme d'un adhésif ou sous la forme d'une résine.

11. Contrôleur selon l'une des revendications précédentes, **caractérisé en ce que** le couvercle de boîtier (4) est en matière plastique ou en métal.

12. Contrôleur selon l'une des revendications précédentes, **caractérisé en ce que** la liaison par fusion de matières entre le couvercle de boîtier (4) et le dispositif de liaison (2, 3) est établie par collage, laminage ou brasage.
